# EUROPEAN PATENT SPECIFICATION

(11) **EP 4 597 085 B1**
(45) Date of publication and mention of the grant of the patent: **04.11.2026**
(21) Application number: 25153400.4
(22) Date of filing: 22.01.2025
(51) Int. Cl.: G01N 21/95, G01N 21/952, G01R 31/12

(54) **SYSTEM AND METHOD TO HANDLE LAX OBJECTS**
SYSTEM UND VERFAHREN ZUR HANDHABUNG VON LAX-OBJEKTEN
SYSTÈME ET PROCÉDÉ DE MANIPULATION D'OBJETS LAX

(30) Priority: 23.01.2024 US 202463623991 P; 17.01.2025 US 202519026912
(43) Date of publication of application: 06.08.2025
(73) Proprietor: TE Connectivity Solutions GmbH, 8200 Schaffhausen (CH)
(72) Inventor: SOLANKI, Swapnilsinh, Middletown, 17057 (US); PRICE III, Edward T., Middletown, 17057 (US)
(74) Representative: Ashton, Gareth Mark

(56) References cited:
- US-A1- 2012 294 506
- US-A1- 2020 049 942
- US-A1- 2020 300 811
- US-A1- 2021 148 997

## Description

This application claims the benefit of U.S. Provisional Patent Application No. 63/623,991, filed January 23, 2024.

The present disclosure relates to object inspection systems, and more particularly, to a visual inspection system for inspecting articles which include lax or flexible components, such as polymer products which include exposed flexible wires.

During manufacturing it is often desired to inspect a product to ensure required accuracy and/or detect defects, by way of example only. Some inspection systems rely on the use of cameras for imaging a product, and subjecting those images to analysis to detect defects. Thus, accurate inspection and/or product imaging requires the precise handling of the product during inspection. This is particularly problematic when some or all of the product is flexible or lax in nature. For example, some mandrel formed polymer products utilize flexible metal wires bonded therewith in order to affect its desired functionality. The presence of these wires, and in particular at locations where they may exit the underlying product and thus are not under control, can interfere with the inspection process. Improved systems and methods for accurately inspecting these and other types of products are desired.

Document US 2012/294506 A1 discloses a method and device for inspecting a traveling wire cable.

Document US 2020/300811 A1 discloses a rope-testing system that combines a magnetization detector with an imaging device positioned a known distance downstream of the detector.

Document US 2020/049942 A1 discloses an inspection apparatus for a cable end in which a mirror apparatus is arranged around a central axis. The cable end to be inspected is positioned along this axis.

Document US 2021/148997 A1 discloses a cable-inspection system in which a ring-camera frame carries a plurality of cameras spaced evenly around its circumference, all viewing the cable that passes through the frame's central axis.

According to the invention as defined in claim 1, a system adapted to inspect an object including a flexible wire includes a feed device feeding the object toward an inspection device, a selectively movable magnet and a selectively movable wire holding fixture. The magnet is adapted to secure to the flexible wire of the object as it approaches the inspection device. The wire holding fixture engages with the wire secured by the magnet and maintains the wire in a predetermined position relative to the object being inspected, for example outside of a field of detection of the inspection device. The flexible wire may extend away and be exposed from the remainder of the object, and the wire holding fixture maintains the exposed flexible wire in a predetermined position relative to the object being inspected, for example outside of a field of detection of the inspection device.

The invention will now be described by way of example with reference to the accompanying Figures, of which:
Figure 1 is an orthogonal view of an exemplary product to be inspected useful for describing embodiments of the present disclosure;
Figure 2 is a partial orthogonal view of an inspection system according to an embodiment of the present disclosure;
Figure 3 is another partial orthogonal view of the inspection system of Figure 2;
Figure 4 is a simplified front view of a produce under inspection by the inspection system of the present disclosure; and

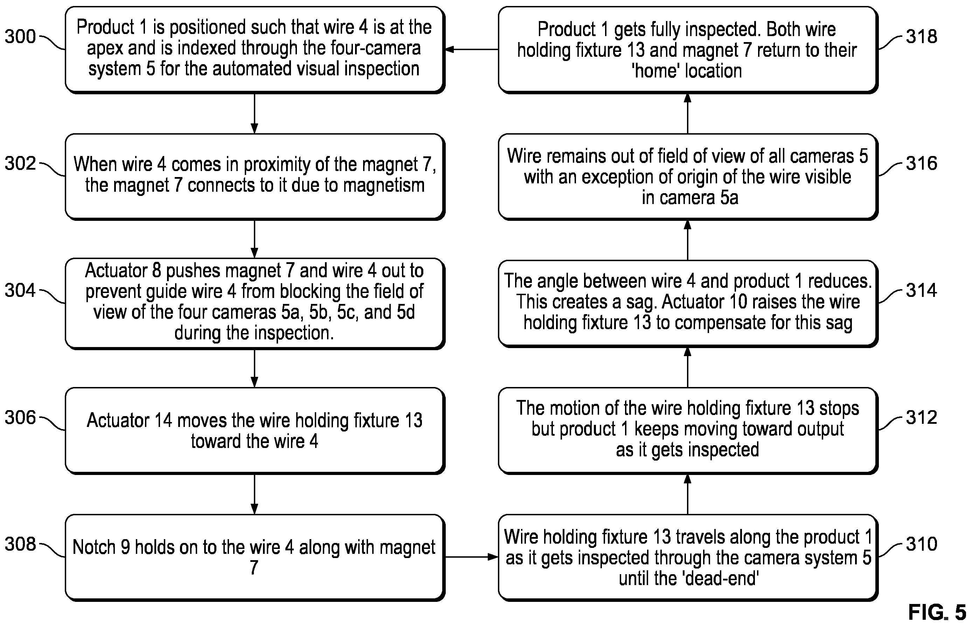

Figure 5 is a simplified process diagram illustrating a flexible object handling process utilized by the inspection system of the present disclosure.

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to an embodiment of the present disclosure, a system for visually inspecting an object including a flexible wire is provided. The system generally includes an inspection device (e.g., a plurality of cameras), and is adapted to receive the object to be inspected in a feed direction (e.g., along an elongated longitudinal axis of the object). The system further includes a magnet configured to secure the flexible wire of the object as it approaches the inspection device, and before it enters a field of view of the inspection device. A first actuator is provided for biasing the magnet and the wire captured thereby from a first position to a second position that is further away from the object to be inspected than the first position. The first actuator may be provided for biasing the magnet and the wire captured thereby from a first position proximal to the object to be inspected to a second position distal to the object to be inspected. Once moved away from the object, a wire holding fixture of the system captures the wire from the second position. A second actuator then translates the wire holding fixture and the wire toward the visual inspection device in the feed direction, as the object to be inspected also approaches the visual inspection device. During translation, the wire holding fixture maintains the wire in a position outside of one or more fields of view of the inspection device. As the wire holding fixture is unable to translate further due to mechanical blockage (e.g., resulting from space limitations of the inspection device and/or inspection system), a third actuator raises or further biases the wire holding fixture, and thus the wire, away from the object, preventing it from sagging or arcing, and ensuring it remains outside of the viewing field(s) of the inspection device as the object inspection is completed.

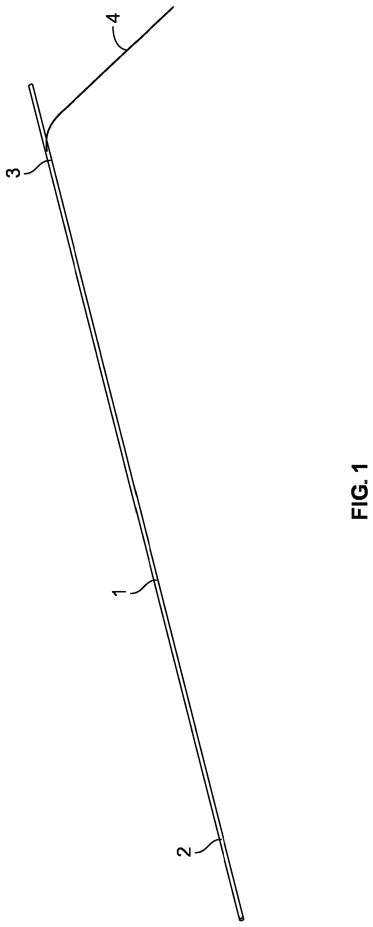

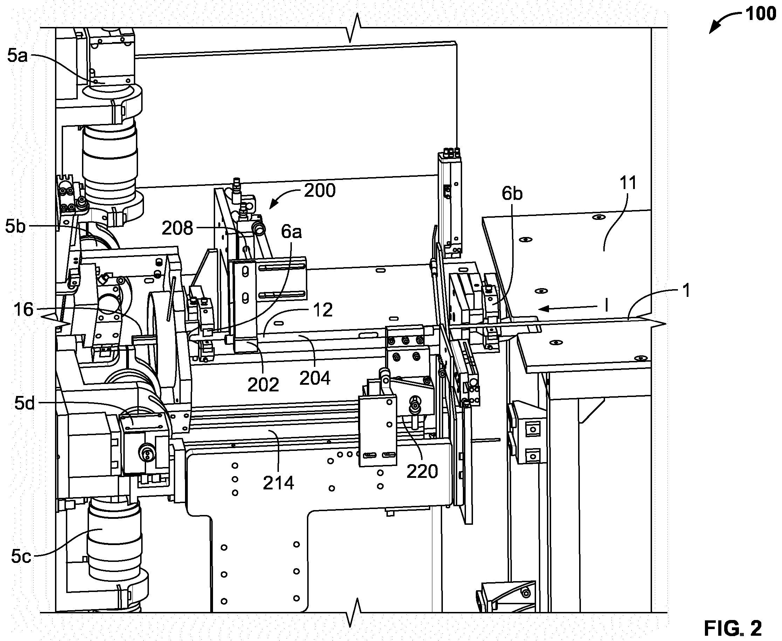

Referring generally to Figure 1, an exemplary product 1 useful for describing the system of the present disclosure may include, for example, a mandrel formed polymer body (e.g., an elongated cylindrical body) onto or into which one or more wires 4 is bonded along its axial direction. The product 1 includes a first end 2 to be fed into an inspection device first, and a second end 3. In order to ensure product quality, the product 1 must be inspected along its length via a product inspection system 100, as shown in Figure 2.

The presence of the wire 4 creates difficulties during an inspection process of the product 1. Specifically, if the exposed wire 4 is captured by imaging devices of the inspection system 100, the image analyzing algorithms adapted to detect defects in the product 1 utilized by the system will often mistake the wire for a defect in the product (e.g., a crack or rupture). Accordingly, as the wire 4 at the end 3 of the product 1 nears the inspection system 100, and specifically the imaging device(s) thereof, the position of the wire 4 must be accurately controlled. For example, the wire 4 must be biased out of a field of view of the system's imaging devices during the inspection process, positioned to limit its visibility, and/or maintained in a consistent, predictable position relative to the product 1 so it can be identified and masked or discarded during image processing.

Referring to Figure 2, the exemplary inspection system 100 includes a plurality of inspection devices, such as imaging devices or cameras. More specifically, the exemplary inspection system 100 includes four cameras 5a, 5b, 5c and 5d arranged radially about a central axis of the product 1, or the axis of elongation of the product. In the exemplary embodiment, the cameras 5a, 5b, 5c, 5d are arranged at 90 degree increments about the product 1, such that images of a top, bottom, left and right side of the product 1 are captured. As shown, the cameras 5a, 5b, 5c, 5d are adapted to image segments of the product 1 as it passes through a funnel 16.

The product 1 is fed, for example, from a table 11 in an inspection or feed direction I, parallel (or coaxial) to the axis of the product. The product 1 may be automatically fed via pairs of grippers 6a, 6b arranged along the product 1 in the feed direction I. The grippers 6a, 6b are adapted to grasp the product 1, and incrementally move or index it in the feed direction I. Of course, other types of feed elements may be used, such as rollers or the like.

As the camera 5a, 5b, 5c, 5d image the product 1, associated image processing software analyzes images of the product in order to detect defects in the product. This may include, for example, taking measurements of the product to detect dimensions for determining if the product 1 falls outside predetermined acceptable ranges or tolerances, inspecting the surface of the product for structural defects, such as cracks, linearity, and the like. If the inspection system 100 detects a defect, the product 1 can be flagged as rejected, and pulled from further manufacturing, processing, or packaging.

As can be visualized from Figures 1 and 2, at the start of an inspection cycle, the wire 4 is exposed only on the end 3 of the product 1. However, when the product 1 has indexed sufficiently such that the wire 4 reaches a location 12 proximate the visual inspection devices (e.g., the cameras), the position of the exposed wire 4 must come under control of the system. This is achieved by a wire handling mechanism 200 according to an embodiment of the present disclosure.

The wire handling mechanism 200 ensures that the wire 4 remains out of a field of view of at least a portion of the cameras 5a, 5b, 5c, 5d. In one embodiment, the mechanism 200 is operative to move the wire 4 such that is not visible to any of the cameras 5a, 5b, 5c, 5d, or to be visible only to, for example, camera 5a for a limited time. During this time, the wire 4 can be masked during image processing as it is held in a consistent position by the handling mechanism 200.

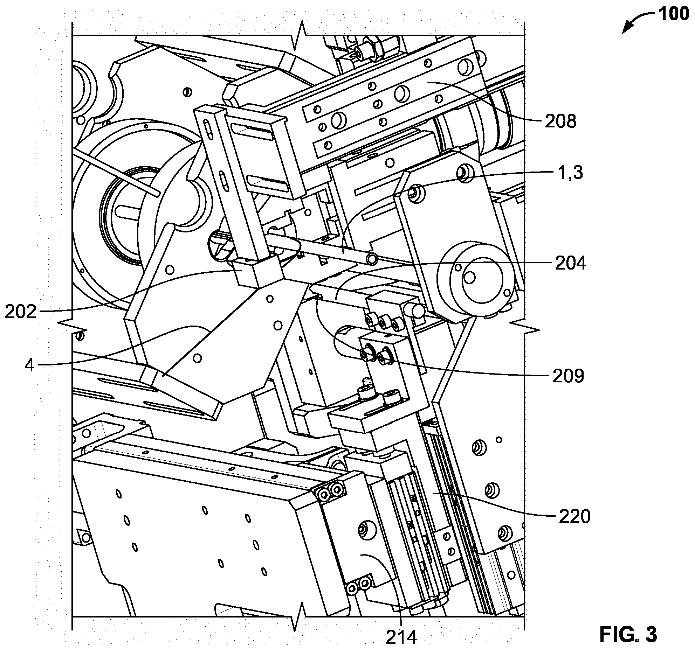

Referring generally now to Figures 2 and 3, the function of the wire handling mechanism 200 will now be described. In one embodiment, the wire handling mechanism 200 includes a movable magnet 202 and a movable wire holding fixture 204. Due to the magnetic properties of the wire 4, as it approaches the magnet 202 proximate the location 12, it attaches thereto. With particular reference to Figure 3, a detailed view of the magnet 202 contacting and holding the wire 4 is shown.

Once the wire 4 is attached to the magnet 202, an actuator 208 extends the magnet outwardly (i.e., horizontally) and away from the product 1. The resulting extended position of the wire 4 permits engagement of the wire by the wire holding fixture 204. Of note, the wire holding fixture 204 operates on a 2-axis system. In particular, an actuator 214 operates to allow the wire holding fixture 204 to travel along the major axis of the product 1 (i.e., in the feed direction), and an actuator 220 enables the wire holding fixture 204 to travel in a vertical direction. As the actuator 208 extends the magnet 202 outwardly along with the wire 4, the actuator 214 moves the wire holding fixture 204 toward the wire 4, such that a notch 209 defined on an end thereof captures the wire.

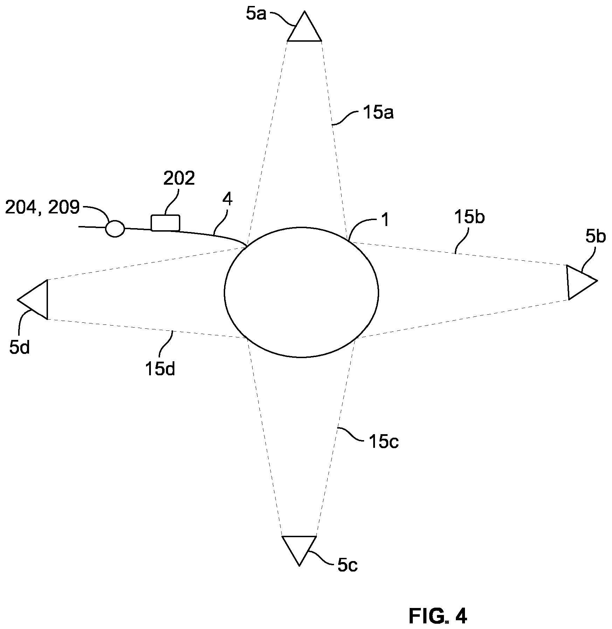

With the wire 4 captured by the wire holding fixture 204, further indexing of the product 1 is matched by like indexing of the wire holding fixture 204 (and thus the wire 4 held in the notch 209) via the actuator 214. This matching indexing maintains a consistent orientation of the wire 4 relative to the cameras 5a, 5b, 5c, 5d. More specifically, Figure 4 shows a cross-sectional representation of the wire 4 attached to the magnet 202, and arranged within the notch 209 of the wire holding fixture 204. As shown, the wire 4 is held outside of the field of views 15a, 15b, 15c, and 15d of the respective cameras 5a, 5b, 5c, 5d. In this way, the mechanism 200 is operative to maintain the wire 4 in an ideal position as the product 1 is inspected.

It should be understood from Figures 2 and 3 that as the wire holding fixture 204 approaches the area of the funnel 16, it is physically prevented from indexing any further in the feed direction. At this point, motion of the wire holding fixture 204 is stopped but product 1 is required to continue moving in the feed direction. As a result, an angle between wire 4 and the major axis of product 1 slowly decreases. This creates a bend, arc or sag in the wire 4 toward an end of the inspection process. In order to remedy this, the actuator 220 is adapted to raise the wire holding fixture 204 vertically to compensate for the bend so that the wire 4 does not fall within the field of view of each of at least cameras 5a, 5b, 5c, 5d, although the wire 4 may be initially visible in the field of view 15a of the camera 5a at the start of the wire handling process. However, this segment of the wire can be accounted for during inspection process. In this way, the mechanism 200 ensures that the wire 4 doesn't hinder the inspection of the product throughout the majority of the cycle.

Figure 4 provides a simplified flow chart illustrating the above described function of a system according to an embodiment of the present disclosure.

In a first step 300, a linear product including a wire extending from an end thereof is indexed through a four camera inspection system.

In a step 302, the wire comes into contact with and connects to a magnet.

In a step 304, an actuator biases the magnet and attached wire away from the product to prevent the wire from entering or blocking the field of view of the cameras during inspection.

In a step 306, once the wire is biased by the magnet, another actuator moves a wire holding fixture toward the wire.

In a step 308, a notch defined in the wire holding fixture captures the wire.

In a step 310, the wire holding fixture travels in the feed direction along with the product during its inspection until it is unable to travel further due to physical blockage of the system.

In a step 312, motion of the wire holding fixture is halted, with the product continuing to move through inspection.

In a step 314, as an angle of the wire relative to the product decreases (e.g., from sagging or bending resulting from the stationary holding fixture), another actuator raises the wire holding fixture to mitigate this reduction in relative angle or bend in the wire.

In a step 316, the wire remains outside of a view of each of the cameras during further inspection.

In a step 318, the product inspection is completed and the wire holding fixture and magnet return to respective initial or home positions.

## Claims

1. A system (100) adapted to inspect an object (1) including a flexible wire (4), comprising:
a feed device(6a, 6b) adapted to feed the object (1) toward an inspection device (5a, 5b, 5c, 5d) in a feed direction;
a movable magnet (202) adapted to secure the wire (4) of the object (1) thereto as it approaches the inspection device (5a, 5b, 5c, 5d); and
a movable wire holding fixture (204) adapted to engage with the wire (4) secured by the magnet (202) and maintain the wire in a predetermined position relative to the object (1) to be inspected.

2. The system (100) of claim 1, further comprising a first actuator (208) operatively connected to the magnet (202) and adapted to position the magnet and the wire (4) secured thereto relative to the object (1) to be inspected.

3. The system (100) claim 2, wherein the first actuator (208) is movable between a first position proximate to the object (1) and a second position distal to the object (1).

4. The system (100) of claim 2 or 3, further comprising a second actuator (214) operatively connected to the wire holding fixture (204) and adapted to position and maintain the wire (4) in a predetermined position relative to the object (1).

5. The system (100) of claim 4, wherein the second actuator (214) is adapted to bias the wire holding fixture (204) in the feed direction as the object (1) moves in the feed direction.

6. The system (100) of claim 4 or 5, further comprising a third actuator (220) operatively connected to the wire holding fixture (204).

7. The system (100) of claim 6, wherein the third actuator (220) is adapted to bias the wire holding fixture (204) in a direction normal to the feed direction.

8. The system (100) of claim 6 or 7, wherein the third actuator (220) biases the wire holding fixture (204) vertically in response to the second actuator (214) stopping motion of the wire holding fixture in the feed direction.

9. The system (100) of claim 8, wherein the vertical motion of the wire holding fixture (204) is operative to remove a bend in the wire (4) resulting from stoppage of the wire holding fixture in the feed direction.

10. The system (100) of any preceding claim, wherein the wire holding fixture (204) defines a notch (209) adapted to capture the wire secured by the magnet (202).

11. The system (100) of claim 10, wherein the notch (209) is open in the feed direction and adapted to capture the wire (1) secured by the magnet (202) as the wire holding fixture (204) is translated in the feed direction.

12. The system of claim 11 when claim 10 is appended to any one of claims 4 to 9, wherein the wire holding fixture (204) is translated in the feed direction by the second actuator (214).

13. The system (100) of any preceding claim, wherein the inspection device (5a, 5b, 5c, 5d) includes a plurality of cameras arranged radially about a central axis of the object to be inspected.

14. The system (100) of claim 12, wherein the wire holding fixture (202) is adapted to maintain the wire (1) outside of a field of view of each or at least one of the plurality of cameras (5a, 5b, 5c, 5d) as the wire holding fixture is translated in the feed direction.

15. A method of inspecting an object (1) that includes an exposed flexible wire (4) with a system (100), comprising:
feeding a (300) portion of the object that does not include the exposed flexible wire through a visual inspection device (5a, 5b, 5c, 5d) in a feed direction;
as the exposed wire approaches the visual inspection device (5a, 5b, 5c, 5d), securing (302) the wire to a magnet;
translating (304) the magnet and the wire away from the object;
capturing (308) the wire with a wire holding fixture in a position in which the wire is outside of a field of view of the visual inspection device (5a, 5b, 5c, 5d);
as the object is continually fed through the visual inspection device, translating (310) the wire holding fixture along with the wire in the feed direction;
stopping (312) the wire holding fixture as it approaches an end of a range of travel in the feed direction; and
translating (314) the wire holding fixture in a direction normal to the feed direction as the object continues toward the visual inspection device (5a, 5b, 5c, 5d).

## Patentansprüche

1. System (100), ausgelegt zur Prüfung eines Objekts (1) mit einem flexiblen Draht (4), das Folgendes umfasst:
eine Zuführvorrichtung (6a, 6b), ausgelegt zum Zuführen des Objekts (1) zu einer Prüfvorrichtung (5a, 5b, 5c, 5d) in einer Zuführrichtung;
einen beweglichen Magnet (202), ausgelegt zum Befestigen des Draht (4) des Objekts (1) daran, wenn es sich der Prüfvorrichtung (5a, 5b, 5c, 5d) nähert; und
eine bewegliche Drahthaltevorrichtung (204), ausgelegt zum Ineingriffkommen mit dem durch den Magneten (202) befestigten Draht (4) und zum Halten des Drahts in einer vorbestimmten Position relativ zu dem zu prüfenden Objekt (1) .

2. System (100) nach Anspruch 1, das ferner einen ersten Aktuator (208) umfasst, der mit dem Magneten (202) wirkverbunden und zum Positionieren des Magneten und des daran befestigten Drahts (4) relativ zu dem zu prüfenden Objekt (1) ausgelegt ist.

3. System (100) nach Anspruch 2, wobei der erste Aktuator (208) zwischen einer ersten Position in der Nähe des Objekts (1) und einer zweiten Position fern von dem Objekt (1) bewegbar ist.

4. System (100) nach Anspruch 2 oder 3, das ferner einen zweiten Aktuator (214) umfasst, der mit der Drahthaltevorrichtung (204) wirkverbunden und zum Positionieren und Halten des Drahts (4) in einer vorbestimmten Position relativ zum Objekt (1) ausgelegt ist.

5. System (100) nach Anspruch 4, wobei der zweite Aktuator (214) zum Vorspannen der Drahthaltevorrichtung (204) in Zuführrichtung ausgelegt ist, während sich das Objekt (1) in Zuführrichtung bewegt.

6. System (100) nach Anspruch 4 oder 5, das ferner einen dritten Aktuator (220) umfasst, der mit der Drahthaltevorrichtung (204) wirkverbunden ist.

7. System (100) nach Anspruch 6, wobei der dritte Aktuator (220) zum Vorspannen der Drahthaltevorrichtung (204) in einer Richtung normal zur Zuführrichtung ausgelegt ist.

8. System (100) nach Anspruch 6 oder 7, wobei der dritte Aktuator (220) als Reaktion darauf, dass der zweite Aktuator (214) die Bewegung der Drahthaltevorrichtung in der Zuführrichtung stoppt, die Drahthaltevorrichtung (204) vertikal vorspannt.

9. System (100) nach Anspruch 8, wobei die vertikale Bewegung der Drahthaltevorrichtung (204) dazu dient, eine durch Stoppen der Drahthaltevorrichtung in Zuführrichtung entstandene Biegung im Draht (4) zu beseitigen.

10. System (100) nach einem vorherigen Ansprich, wobei die Drahthaltevorrichtung (204) eine Kerbe (209) definiert, die zum Aufnehmen des durch den Magneten (202) befestigten Drahts ausgelegt ist.

11. System (100) nach Anspruch 10, wobei die Kerbe (209) in Zuführrichtung offen und zum Aufnehmen des durch den Magneten (202) befestigten Drahts (1) ausgelegt ist, während die Drahthaltevorrichtung (204) in Zuführrichtung verschoben wird.

12. System nach Anspruch 11, wenn Anspruch 10 einem der Ansprüche 4 bis 9 angefügt ist, wobei die Drahthaltevorrichtung (204) durch den zweiten Aktuator (214) in Zuführrichtung verschoben wird.

13. System (100) nach einem vorherigen Anspruch, wobei die Prüfvorrichtung (5a, 5b, 5c, 5d) mehrere Kameras umfasst, die radial um eine Mittelachse des zu prüfenden Objekts angeordnet sind.

14. System (100) nach Anspruch 12, wobei die Drahthaltevorrichtung (202) zum Halten des Drahts (1) außerhalb des Sichtfelds jeder oder zumindest einer der mehreren Kameras (5a, 5b, 5c, 5d) ausgelegt ist, während die Drahthaltevorrichtung in Zuführrichtung verschoben wird.

15. Verfahren zum Prüfen eines Objekts (1), das einen freiliegenden flexiblen Draht (4) aufweist, mit einem System (100), das Folgendes umfasst:
Zuführen (300) eines Teils des Objekts, der den freiliegenden flexiblen Draht nicht enthält, durch eine visuelle Prüfvorrichtung (5a, 5b, 5c, 5d) in einer Zuführrichtung;
Befestigen (302) des Drahts an einem Magneten, während sich der freiliegende Draht der visuellen Prüfvorrichtung (5a, 5b, 5c, 5d) nähert;
Verschieben (304) des Magneten und des Drahts vom Objekt weg;
Erfassen (308) des Drahts mit einer Drahthaltevorrichtung in einer Position, in der sich der Draht außerhalb des Sichtfelds der visuellen Prüfvorrichtung (5a, 5b, 5c, 5d) befindet;
Verschieben (310), während das Objekt kontinuierlich durch die visuelle Prüfvorrichtung geführt wird, der Drahthaltevorrichtung zusammen mit dem Draht in Zuführrichtung;
Stoppen (312) der Drahthaltevorrichtung, wenn sie sich einem Ende eines Verfahrbereichs in Zuführrichtung nähert; und
Verschieben (314) der Drahthaltevorrichtung in einer Richtung normal zur Zuführrichtung, während sich das Objekt weiter in Richtung der visuellen Prüfvorrichtung (5a, 5b, 5c, 5d) bewegt.

## Revendications

1. Système (100) conçu pour inspecter un objet (1) incluant un fil flexible (4), comprenant :
un dispositif d'avancement (6a, 6b) conçu pour faire avancer l'objet (1) vers un dispositif d'inspection (5a, 5b, 5c, 5d) dans une direction d'avancement ;
un aimant mobile (202) conçu pour fixer le fil (4) de l'objet (1) sur celui-ci au fur et à mesure qu'il se rapproche du dispositif d'inspection (5a, 5b, 5c, 5d) ; et
un montage de retenue de fil mobile (204) conçu pour une mise en prise avec le fil (4) fixé par l'aimant (202) et pour maintenir le fil dans une position prédéterminée relativement à l'objet (1) devant être inspecté.

2. Système (100) de la revendication 1, comprenant en outre un premier actionneur (208) connecté de manière opérationnelle à l'aimant (202) et conçu pour positionner l'aimant et le fil (4) fixé à celui-ci relativement à l'objet (1) devant être inspecté.

3. Système (100) de la revendication 2, dans lequel le premier actionneur (208) peut être déplacé entre une première position à proximité de l'objet (1) et une deuxième position distale par rapport à l'objet (1).

4. Système (100) de la revendication 2 ou 3, comprenant en outre un deuxième actionneur (214) connecté de manière opérationnelle au montage de retenue de fil (204) et conçu pour positionner et maintenir le fil (4) dans une position prédéterminée relativement à l'objet (1).

5. Système (100) de la revendication 4, dans lequel le deuxième actionneur (214) est conçu pour solliciter le montage de retenue de fil (204) dans la direction d'avancement au fur et à mesure que l'objet (1) se déplace dans la direction d'avancement.

6. Système (100) de la revendication 4 ou 5, comprenant en outre un troisième actionneur (220) connecté de manière opérationnelle au montage de retenue de fil (204).

7. Système (100) de la revendication 6, dans lequel le troisième actionneur (220) est conçu pour solliciter le montage de retenue de fil (204) dans une direction perpendiculaire à la direction d'avancement.

8. Système (100) de la revendication 6 ou 7, dans lequel le troisième actionneur (220) sollicite le montage de retenue de fil (204) verticalement en réponse au mouvement d'arrêt du deuxième actionneur (214) concernant le montage de retenue de fil dans la direction d'avancement.

9. Système (100) de la revendication 8, dans lequel le mouvement vertical du montage de retenue de fil (204) opère de façon à éliminer une courbure dans le fil (4) résultant de l'action d'arrêt du montage de retenue de fil dans la direction d'avancement.

10. Système (100) de n'importe quelle revendication précédente, dans lequel le montage de retenue de fil (204) définit une encoche (209) conçue pour saisir le fil fixé par l'aimant (202).

11. Système (100) de la revendication 10, dans lequel l'encoche (209) est ouverte dans la direction d'avancement et conçue pour saisir le fil (1) fixé par l'aimant (202) au fur et à mesure que le montage de retenue de fil (204) effectue un mouvement de translation dans la direction d'avancement.

12. Système (100) de la revendication 11 lorsque la revendication 10 est jointe à n'importe laquelle des revendications 4 à 9, dans lequel le montage de retenue de fil (204) est soumis à un mouvement de translation dans la direction d'avancement par le deuxième actionneur (214).

13. Système (100) de n'importe quelle revendication précédente, dans lequel le dispositif d'inspection (5a, 5b, 5c, 5d) inclut une pluralité de caméras agencées radialement autour d'un axe central de l'objet devant être inspecté.

14. Système (100) de la revendication 12, dans lequel le montage de retenue de fil (202) est conçu pour maintenir le fil (1) en dehors d'un champ de vision de chaque caméra ou d'au moins une caméra de la pluralité de caméras (5a, 5b, 5c, 5d) au fur et à mesure que le montage de retenue de fil effectue un mouvement de translation dans la direction d'avancement.

15. Procédé d'inspection d'un objet (1) qui inclut un fil flexible exposé (4) à l'aide d'un système (100), comprenant :
le fait de faire avancer une portion (300) de l'objet qui n'inclut pas le fil flexible exposé à travers un dispositif d'inspection visuelle (5a, 5b, 5c, 5d) dans une direction d'avancement ;
au fur et à mesure que le fil exposé s'approche du dispositif d'inspection visuelle (5a, 5b, 5c, 5d), le fait de fixer (302) le fil à un aimant ;
le fait de faire effectuer un mouvement de translation (304) à l'aimant et au fil en éloignement de l'objet ;
le fait de saisir (308) le fil à l'aide d'un montage de retenue de fil dans une position dans laquelle le fil est en dehors d'un champ de vision du dispositif d'inspection visuelle (5a, 5b, 5c, 5d) ;
au fur et à mesure que l'objet est continuellement avancé à travers le dispositif d'inspection visuelle, le fait de faire effectuer un mouvement de translation (310) au montage de retenue de fil en conjonction avec le fil dans la direction d'avancement ;
le fait d'arrêter (312) le montage de retenue de fil au fur et à mesure qu'il s'approche d'une extrémité d'une plage de déplacement dans la direction d'avancement ; et
le fait de faire effectuer un mouvement de translation (314) au montage de retenue de fil dans une direction perpendiculaire à la direction d'avancement au fur et à mesure que l'objet continue vers le dispositif d'inspection visuelle (5a, 5b, 5c, 5d).
